Europäisches Patentamt

European Patent Office

Office européen des brevets

(11) Publication number: **0 066 694**
**B1**

# EUROPEAN PATENT SPECIFICATION

(45) Date of publication of patent specification: **11.03.87**

(51) Int. Cl.⁴: **H 01 L 21/66**

(21) Application number: **82103180.4**

(22) Date of filing: **15.04.82**

(54) Method for inspecting integrated circuit chips.

(30) Priority: **10.06.81 US 272421**

(43) Date of publication of application:
**15.12.82 Bulletin 82/50**

(45) Publication of the grant of the patent:
**11.03.87 Bulletin 87/11**

(84) Designated Contracting States:
**DE FR GB IT**

(56) References cited:
**DE-A-2 230 277**
**DE-A-2 439 988**
**DE-A-2 719 696**

**NASA CONTRACTOR REPORT, no. CR-721, 1967, pages 10-13, Washington, US. J. LOMBARDI et al.: "High reliability screening of semiconductor and integrated circuit devices", page 10, lines 11-24; page 12, lines 30-32**

**IBM TECHNICAL DISCLOSURE BULLETIN, vol. 21, no. 10, March 1979, pages 4041-4042, New York, US. J. P. KIRK et al.: "Chip motion monitor"**

(73) Proprietor: **International Business Machines Corporation**
**Old Orchard Road**
**Armonk, N.Y. 10504 (US)**

(72) Inventor: **Fouts, David Perry**
**Grist Mill Lane**
**Stanfordville, NY 12581 (US)**
Inventor: **Jaspal, Jasvir Singh**
**25 Brookland Farm Road**
**Poughkeepsie, NY 12601 (JP)**
Inventor: **Roush, Walden Bennet**
**Rossway Road**
**Pleasant Valley, NY 12569 (US)**
Inventor: **Sullivan, Michael James**
**Rd. Nr. 1 Church Road Box 367**
**Redhook, NY 12571 (US)**

(74) Representative: **Barth, Carl Otto et al**
**IBM Deutschland GmbH Patentabteilung**
**Schönaicher Strasse 220**
**D-7030 Böblingen (DE)**

(56) References cited:
**REVIEW OF THE ELECTRICAL COMMUNICATION LABORATORIES, vol. 27, no. 1-2, January-February 1979, pages 92-96, New York, US. I. NISHI et al.: "Full wafer size LSI mounting"**

Courier Press, Leamington Spa, England.

## Description

This invention relates to semiconductor device fabrication and, more particularly, to the determination and identification of integrated circuit chips which become misjoined or damaged in face-down relationship to a supporting substrate carrier.

US Patent No. 3 993 123 describes a package for encapsulating semiconductor devices with provision for cooling of the devices or for the dissipation of heat during operation of the device. In this patent, a gas encapsulated cooling unit is provided for one or more heat generating components, e.g. integrated circuit chips, mounted on a supporting substrate carrier of suitable dielectric such as alumina ceramics, glass-ceramic, and the like. The mounting specifically described in this patent is by the flip-chip or face-down solder-bonding techniques. The components are packaged on the substrate by a heat conductive cap which is sealed to the substrate to enclose the heat generating components. The wall of the cap opposite the substrate contains elongated openings or bores which extend toward the heat generating components and on the same centers with respect thereto. A resilient member, such as a compression spring, is disposed in bores in the rear thereof. A thermal conductive element, e.g. a piston, is inserted in the bores, and is biased by the springs into thermal contact with the heat generating components.

The integrated circuit chips are normally concurrently formed in a mother wafer substrate from which they are separated or diced. The original wafer is initially polished for planarity and thickness which results in a mirror surface, which is retained in the diced chips having substantially mirror polished backsides, with the opposite side covered with an insulator, such as quartz, with suitable terminal solder contacts for the face-down or flip chip bonding to solder joinable sites on a supporting substrate carrier. The chip carrier solder joinable sites are surrounded by non-solderable or non-wettable areas so that when the solder between the carrier sites and semiconductor device contact sites melt and merge, surface tension of the solder causes it to fall in a shape to support the chip in spaced relation above the carrier.

In handling of the above cooled package, since the pistons are moveable under bias within the bores, these pistons are free to move in retraction against the bias springs, and return under the force of the spring so as to impact the semiconductor chips. Such piston impact can produce plastic deformation in the solder joints and accompanying deformation or bending of the semiconductor chips to place them under stress. Such deformation of the chips can be conducive to fracture of the solder joints or their separation from the chip or carrier surfaces, to stress of the quartz insulating layer on the chips, as well as alteration of the electrical characteristics of the integrated circuit. As will be appreciated, such deformation can also be induced in the chips by various tool handling means, as for example in the fabrication of the package. Similarly, stresses can be induced in the mother wafer during processing of the integrated circuits, as for example during diffusion and coating operations with compositions having varied expansion coefficients. Since these problems can effect the integrity of the devices, it is desirable to provide means for the detection of potentially malfunctioning units. Presently available means can involve complex electrical testing techniques which require comparable complex testers, which not only can fail to insure complete reliability of detection, but also detract from the economic viability of the manufacturing operation.

One optical method for detecting deformation in planar surfaces is described in US Patent No. 2 867 149 which is directed to the inspection of singular surfaces as contrasted to multi-surfaces of a plurality of chips as employed in the above described cooled chip package. Application of this patent's technique to the detection of deformed chips utilizing a coarse grid (e.g. a window screen) and a diffraction grating of about 530 lines per mm. (13,400 lines per inch) failed to detect any bent chips by any one of eight operators. Although the diffraction grating may cast shadows, there was no definition of lines or they were invisible. Although the window screen did cast shadows which were big enough to see, the only position where they could be seen with ease is by looking through the screen, as shown in the patent. Also the shadows were only sufficiently distinct on a rough or grandular surface (e.g. ceramic).

Heretofore, there is no known way to screen or inspect chip products, thereby allowing for unknown failure rates in field products.

The above drawbacks in inspecting bent or deformed semiconductor devices solder mounted face-down on a supporting carrier substrate can be overcome by a novel technique of reflecting a grid pattern from a mirror polished surface of the device substrate, and observing the reflected image for distortion. Increased sensitivity can be obtained by adjusting the grid size, grid-to-substrate distance, and substrate-to-operator distance. For example, using a 1 cm grid size, 50 cm grid-to-substrate distance and 50 cm substrate-to-operator distance, a warpage or bend in the device substrate of about 0.15 µm (1500Å) is readily detectable. This grid technique permits evaluating the surface of the device substrate for warpage to a specification of within ±0.15 µm (±1500Å), or better if desired. The inspection can be performed in short times (e.g. few minutes) by relatively unskilled operators.

In its broad concept, this invention comprehends its application to inspection of the mirror polished surfaces of a variety of substrates (e.g. stress-deformed processed semiconductor wafers).

One way of carrying out the invention is described in detail below with reference to the drawings which illustrate an embodiment of the invention, wherein:

Fig. 1 is a cross-sectional view illustrating a multi-chip cooled module package employed for purposes of illustrating the application of this invention.

Fig. 2 is a cross-sectional view illustrating a simplified version of Fig. 1, showing a single thermal conductor arrangement for cooling a single chip.

Fig. 3 is a schematic cross-sectional view of a semiconductor chip solder joined in normal bonding to a supporting carrier substrate.

Fig. 4 is a schematic cross-sectional view illustrating, in conceptional exaggeration, the deformation induced in a solder joined semiconductor chip during handling of device package.

Fig. 5 is a schematic view in perspective illustrating the application of this invention to the detection of warpage in solder mounted semiconductor chips.

Fig. 6 illustrates the reflected image, of the grid employed in an embodiment from an instressed chip solder mounted to a carrier substrate.

Fig. 7 illustrates the reflected grid image from a surface of a stress deformed chip.

Fig. 8 is a Tallystep Trace of an impact deformation of a chip solder mounted to a carrier substrate.

Fig. 9 graphically shows data for a plurality of chips mounted to a carrier substrate.

Fig. 10 is another schematic representation of the application of this invention to the inspection of a processed stressed mother wafer.

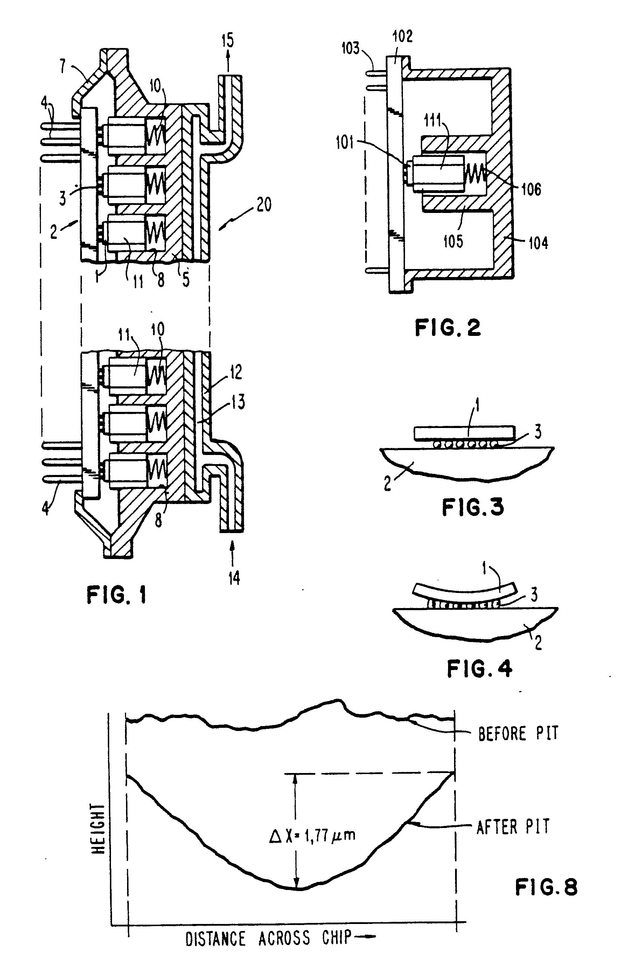

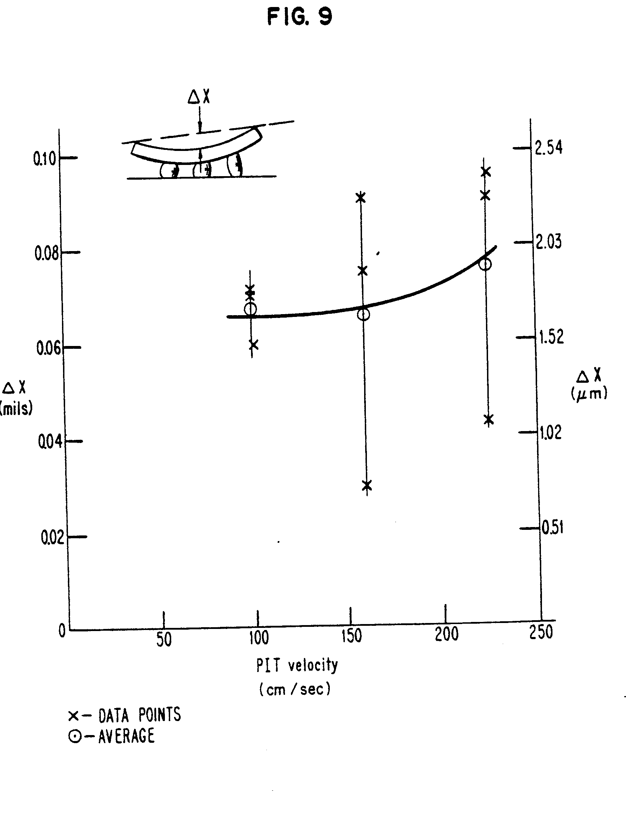

Referring to Fig. 1, there is shown a cross-sectional view of a gas encapsulated module 2 for providing cooling of a plurality of solid state electronic chips 1 to be cooled. As is well known, the chips consist of solid state integrated circuits and devices which are densely packed on each chip. The power consumed in the circuits within the chip generates heat which must be removed from the chips. Since the various circuits have different power requirements, and since the integrated components thereof must be maintained within certain temperature ranges for reliable operation, the cooling must be of such character as to maintain the chip temperatures within the required operating range.

The chips 1 are mounted by solder mounds 3, on one side of a dielectric carrier substrate 2, generally made of alumina ceramic, glass-ceramic and the like, which has pins 4 extending from the other side thereof. These connecting pins 4 provide for plugging of the module into a mother board (not shown) which normally can carry auxiliary circuits, etc. A container or cap 5 is attached to the carrier 2 by means of a flange 7 which extends from the periphery of the substrate 2 to the cap 5. The cap 5 is made of a heat conductive material such as copper, aluminum and the like. The cap 5 is sufficiently thick to provide the bores 8 therein, and in which are inserted a compression bias spring 10 and slidably mounted heat conductive piston members 11 which are biased to abut in surface engagement with the backsides or top surfaces of the chips 1. The heat accumulated in the cap 5 from each of pistons 11 is transferred to a cold plate 12 which is attached to the cap. This cold plate has a cooling liquid circulating within internal channels 13 via the respective inlet and outlet 14 and 15.

Fig. 2 depicts a simplified version. A single chip 101 is shown mounted on a dielectric carrier substrate 102 which has pins 103 extending from the opposite side for plugging the unit into a board. The cap 104 is sealed to the substrate 102 to enclose the chip 101. The cap has a central extension 105 which extends from the top of the cap into the encapsulated region. The extension has a bore in which is contained a compression spring 106 and a slidable heat conductive piston 111 which is biased against the backside of chip 101. The encapsulated region within cap 104 is evacuated and an inert gas, such as helium, is placed therein under slight positive pressure to prevent leakage of the external ambient into the cap interior.

Fig. 3 shows the normal mounting of the chips 1 by solder mounds 3 to the dielectric carrier substrate 2.

Since the pistons 11 are slidably mounted in the cap bores, they are free to move against the bias springs 10 during handling, vibration and shock, with resultant return to impact on the chips 1. These impact returns of pistons 11 against chips 1 can produce plastic deformation of the solder mounds 3 with concurrent elastic deformation of the chips, as shown in Fig. 4, which can alter the electrical characteristics of the devices and place its passivating coating in stress. Such stressing of the coating, e.g. quartz, can induce cracking thereof with malfunction of the electric package. The non-planarity of the backside of the chip is an indication of the severity of the impact blows which this invention can identify the deformed chips from a plurality thereof as shown in Fig. 1.

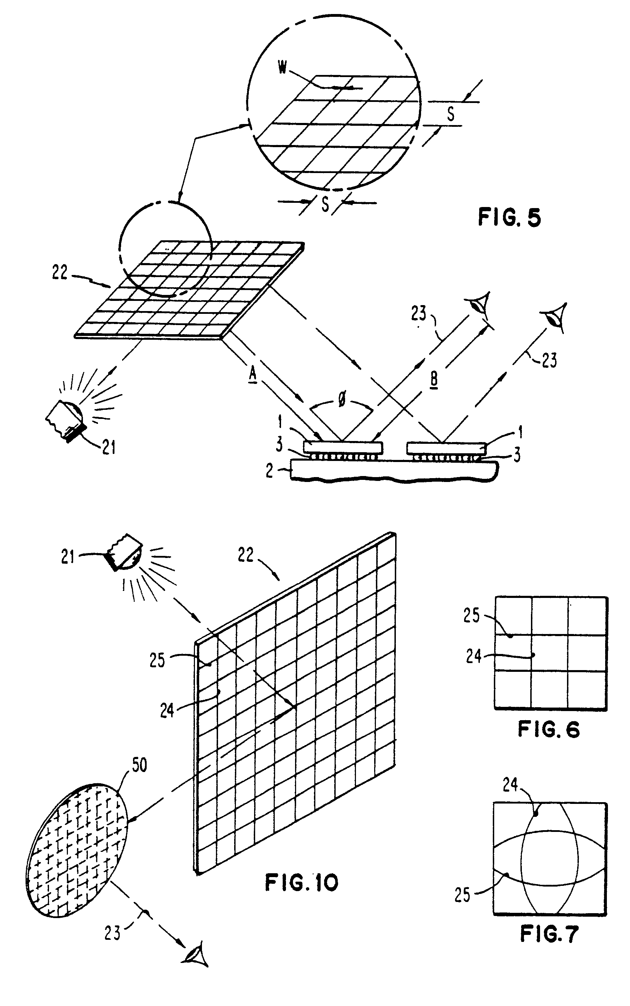

In its broad concept, as shown in Fig. 5, this inspection technique comprises the removal of the cap 12 from module 2, and reflection of a light 21 illuminated grid 22 from the mirror polished back surfaces of the chips 1, and viewing the reflected image 23. The distortion by a bent chip results, as shown in Fig. 7, in a curved line 24 and/or 25 or a "pinched skin" of a square grid 22 (which can be comprised of lines 24 and 25 disposed in normal extension to each other). The grid image distortion is evidenced at each chip (Fig. 7 and Fig. 4) which is stress deformed, whereas the grid images remains square (Fig. 6) in the absence of deformation or bending of the chip as shown in Fig. 3.

A distorted reflected image (Fig. 7) will indicate that the chip was bent, e.g. by piston 11 impacts, and therefore the possibility of cracking of the dielectric passivating coating (e.g. quartz) about and adjacent the solder joints 3 is much greater than for unbent or undeformed chips.

The set-up for obtaining maximized ease of use of the reflected technique for locating the (elastically) deformed or bent chips is shown in Fig. 5, which comprises the grid 22 and a light source 21. In one application comprising the solder mounting of 100 chips 4.7×4.7 mm on a 9.0 cm×9.0 cm alumina ceramic substrate (in an X—Y distribution), an appropriate grid size was found to be about 305×203 mm (12×8 inches) with a grid line width W (see Fig. 5) about 0.76 mm (0.03 inches). Maximum sensitivity was obtained when one square of the grid is at least smaller than the chip size as reflected from the mirror polished back of the chip. For the chip sizes indicated, one desired reflected grid square side "S" would be about 3.05×3.05 mm (0.12×0.12 inches). This condition is satisfied if

$$\text{(in mm)} \quad \frac{3.05}{A} = \frac{S}{(A+B)}$$

$$\text{(in inches)} \quad \frac{0.120}{A} = \frac{S}{(A+B)}$$

where the terms are as defined in Fig. 5. In conformance, it was found that a grid size of approximately S=6.35 mm (S=0.25 inches) with A=B=305 mm (A=B=12 inches) and $\phi$=45° yielded excellent results. This specifically dimensioned system enabled the resolution of angular deflection of the reflected grid lines, of about 0.5 seconds of arc which corresponds to a center deflection of the chips of one μm or less. For a piston impact test (PIT) of 100 cm/second which can be expected to cause about a 2 μm deflection in the chip center, there is ample resolution to spare. It is noted that the degree of resolution can be significantly increased if the length of the optical lever (A+B) is increased.

In order to obtain quantitative data concerning this inspection technique, 9 chips solder mounted on a 3×3 array on an alumina substrate were impacted at three different PIT velocities: 100, 160 and 225 cm/sec. The curvature of the chips was then measured by obtaining a Tallystep Trace across the entire back of the chip (the chips were also profiled before impact to assure reasonable initial flatness). The profiles in Fig. 8 show exact replication of Tallystep data from one of the chips before and after 100 cm/sec PIT. As shown, this chip had a remnant center deflection Δ of about 1.77 μm (70 microinches) due to the PIT. Additional Tallystep data for chips is shown in Fig. 9.

When viewed using the reflected grid technique of this invention, the grid reflection appears as shown in Fig. 6 for an unimpacted chip, while the reflection of the square grid after PIT appears as shown in Fig. 7.

The data obtained also showed only a modest increase in Δx as the PIT velocity was increased from 100 to 225 cm/sec. The threshold for quartz cracking is well above 100 cm/sec and therefore, any chip with potentially cracked quartz can be readily detected and replaced on the carrier substrate.

Fig. 9 graphically shows deflection data for the chips piston-impacted at 100 cm/sec, 160 cm/sec and 225 cm/sec.

Fig. 10 shows the application of this invention to the inspection of a wafer 50 for determining location of bent, warped or stressed regions (e.g. chip areas) therein which may have resulted from the various processing stages employed in the fabrication of integrated circuits.

## Claims

1. A method for analyzing the deformation of a substantially planar, reflective surface at various stages of manufacturing integrated circuit devices, characterized by the steps of:
   providing an illuminated grid (22) of orthogonal straight lines (22, 25) such that the grid is parallel to and off-set with respect to said surface, and
   imaging the grid using light rays that come from the grid and are specularly reflected at the substantially planar surface, so that observed bended grid lines indicate a deformation of the substantially planar surface (1).

2. The method of claim 1, wherein the grid (22) consists of squares with a square side length of S≤3(A+B)/A, A being the distance between grid and the reflecting surface and B being the viewing distance to the reflecting surface.

3. The method of claim 2, wherein A and B are approximately equal.

4. The method of one of the claims 1—3, wherein the substantially planar substrate is composed of a plurality of semiconductor chips (1) arranged face-down on a supporting planar carrier (2), all chips having reflective surfaces on their reverse side.

5. The method of claim 4, wherein a grid (22) is used whose squares are smaller than the surface of each of the chips (1).

## Patentansprüche

1. Verfahren zur Analyse der Verformung einer im wesentlichen planaren, reflektierenden Oberfläche in verschiedenen Herstellungsstufen von integrierten Schaltungsvorrichtungen, gekennzeichnet durch folgende Schritte:
   Vorsehen eines beleuchteten Gitters (22) aus orthogonalen geraden Linien (22, 25), so daß das Gitter in Bezug auf die Oberfläche parallel und versetzt ist, sowie
   Abbilden des Gitters unter Verwendung von Lichtstrahlen, welche vom Gitter kommen und von der im wesentlichen planaren Oberfläche spiegelnd reflektiert werden, so daß beobachtete gebogene Gitterlinien auf eine Verformung der im wesentlichen planaren Oberfläche (1) hinweisen.

2. Verfahren nach Anspruch 1, worin das Gitter (22) aus Quadraten mit einer Seitenlänge von S≤3 (A+B)/A besteht, wobei A die Entfernung zwischen Gitter und der spiegelnden Oberfläche sowie B die Beobachtungsentfernung zur spiegelnden Oberfläche darstellen.

3. Verfahren nach Anspruch 2, worin A und B ungefähr gleich sind.

4. Verfahren nach einem der Ansprüche 1 bis 3, worin die im wesentlichen planare Oberfläche aus mehreren Halbleiterchips (1) besteht, welche mit der Oberfläche nach unten auf einem stützenden ebenen Träger (2) angeordnet sind, wobei alle Chips auf ihrer Rückseite spiegelnde Oberflächen aufweisen.

5. Verfahren nach Anspruch 4, worin ein Gitter (22) verwendet wird, dessen Quadrate kleiner sind als die Oberfläche von jedem der Chips (1).

**Revendications**

1. Procédé pour analyser la déformation d'une surface réfléchissante essentiellement plane à différents stades de la fabrication de dispositifs à circuits intégrés, caractérisé par les phases opératoires consistant à:

— disposer une grille éclairée (22) formée de traits rectilignes perpendiculaires (22, 25), de manière que la grille soit parallèle et décalée par rapport à ladite surface, et
— former l'image de la grille en utilisant des rayons lumineux qui émanent de la grille et sont réfléchis selon une réflexion spéculaire au niveau de la surface essentiellement plane, de sorte que les traits coudés observés de la grille indiquent une déformation de la surface essentiellement plane (1).

2. Procédé selon la revendication 1, selon lequel la grille (22) est constituée par des carrés possédant une longueur de côté S≤3 (A+B)/A, A étant la distance entre la grille et la surface réfléchissante et B étant la distance d'observation jusqu'à la surface réfléchissante.

3. Procédé selon la revendication 2, selon lequel A et B sont approximativement identiques.

4. Procédé selon l'une des revendications 1—3, selon lequel le substrat essentiellement plan est constitué par une pluralité de microplaquettes à semiconducteurs (1) disposées leur face tournée vers le bas sur un support plan (2), toutes les microplaquettes comportant des surfaces réfléchissantes sur leur face arrière.

5. Procédé selon la revendication 4, selon lequel on utilise une grille (22), dont les carrés sont plus petits que la surface de chacune des microplaquettes (1).

FIG. 2

FIG. 1

FIG. 3

FIG. 4

HEIGHT

BEFORE PIT

AFTER PIT

$\Delta X = 1{,}77 \,\mu m$

DISTANCE ACROSS CHIP

FIG. 8

# FIG. 9

FIG. 5

FIG. 6

FIG. 7

FIG. 10